(19) Europäisches Patentamt / European Patent Office / Office européen des brevets

(11) **EP 4 787 650 A1**

(12) **EUROPEAN PATENT APPLICATION**

(43) Date of publication:
05.08.2026 Bulletin 2026/32

(21) Application number: 26156027.0

(22) Date of filing: 03.02.2026

(51) International Patent Classification (IPC):
*H02J 3/06* $^{(2026.01)}$       *H02J 13/12* $^{(2026.01)}$
*H02J 13/10* $^{(2026.01)}$

(52) Cooperative Patent Classification (CPC):
**H02J 3/06; G01R 19/2513; H02J 13/12;**
H02J 13/10; H02J 2105/32

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: 04.02.2025 US 202519044988

(71) Applicant: ABB Schweiz AG
5400 Baden (CH)

(72) Inventors:
• RAZEGHI-JAHROMI, Mohammad
Raleigh, 27606 (US)
• CHOOBINEH, Moein
Raleigh, 27606 (US)
• RODRIGUES, Rostan
Raleigh, 27603 (US)
• MELESE, Amanuel Birhanu
Raleigh, 27606 (US)

(74) Representative: **Zimmermann & Partner**
Patentanwälte mbB
P.O. Box 330 920
80069 München (DE)

(54) **SYSTEMS AND METHODS FOR POWER SYSTEM STATE ESTIMATION USING SEMIDEFINITE RELAXATION (SDR)**

(57)     A method and a system for power system state estimation are provided. The system can include one or more processors and a memory storing computer instructions, which when executed cause the system to a system can comprise one or more processor and a memory storing computer instructions. The computer instructions, when executed by the one or more processors, can cause the one or more processors to acquire, from remote terminal units, measurement data of a plurality of parameters of a power system, acquire network topology data of the power system, and determine estimates of a plurality of states of the power system using the measurement data, the network topology data and a semi definite relaxation formulation. The semidefinite relaxation formulation can include a convex lower bound approximation of a rank function of an augmented state matrix.

FIG. 1

**Description**

TECHNICAL FIELD

The field of the disclosure relates to power system state estimation and, in particular, to systems and methods for estimating power system state(s) using a novel semidefinite relaxation (SDR) approach.

BACKGROUND

A power system or power grid is typically a large and complex interconnected network for generating and delivering electricity to consumers. The power system can include various types of power plants, substations or transformers, transmission lines, distribution lines and control center to continuously provide electric power according to predefined parameters for various consumers. Such parameters can include the voltage value, the electric current value and frequency of the electricity delivered to each consumer. The parameters can also include the voltages and electric currents of the electric power flowing the transmission lines and distribution lines. The control center can control the operation of power system to balance electricity supply and demand. For instance, the control center can continuously adjust the output of power plants to meet the fluctuating energy needs of consumers throughout the day. The balancing of electricity supply and demand allows for maintaining grid stability and prevents power outages.

To continuous balance the electricity supply, the control center or respective systems monitor various parameters or states of the power system based on measured values at various points or nodes of the power grid. In particular, the control center or system(s) thereof can estimate states (or parameters) of the power system based on the measured values to determine a real-time (or near real time) picture of the operating conditions of the power grid. The control center or system(s) thereof can process measurements from various sensors to determine the states or values of specific parameters of the power system of key system.

Embodiments described herein provide a novel and improved state estimation approach for power systems.

SUMMARY

According to one aspect, a system for power system state estimation can comprise one or more processor and a memory storing computer instructions. The computer instructions, when executed by the one or more processors, can cause the one or more processors to acquire, from remote terminal units, measurement data of a plurality of parameters of a power system, acquire network topology data of the power system, and determine estimates of a plurality of states of the power system using the measurement data, the network topology data and a semidefinite relaxation formulation. The semidefinite relaxation formulation can include a convex lower bound approximation of a rank function of an augmented state matrix.

In some implementations, the one or more processors can be configured to acquire the measurement data in real time or near real time.

In some implementations, the plurality of parameters of the power system include at least one of one or more active power flow parameters, one or more reactive power flow parameters, one or more power injection parameters, one or more voltage magnitude parameters, one or more voltage phase parameters, one or more current magnitude parameters, or one or more current phase parameters.

In some implementations, the plurality of states of the power system can include voltage magnitudes and voltages phases of a plurality of buses of the power system.

In some implementations, the convex lower bound approximation can be based on a convex envelope of the rank function of the augmented state matrix, the convex envelope defined in terms of a nuclear norm of the augmented state matrix.

In some implementations, the semidefinite relaxation formulation is convex.

In some implementations, the semidefinite relaxation formulation can include one or more constraints that are linearly related to the plurality of states of the power system. The one or more constraints can include at least one of, an equality constraint related to voltage parameters of the power system, an equality constraint related to current parameters of the power system, an equality constraint related phase parameters of the power system, or an equality constraint related to line admittance parameters of the power system.

In some implementations, the network topology data can include one or more states of one or more circuit breakers or circuit switches.

In some implementations, the one or more processors can be configured to determine, based on the estimates of the plurality of states of the power system, whether the power system is operating in normal operation conditions.

In some implementations, the one or more processors can configured, upon determining that the power system is not operating in normal operation conditions, to perform at least one of generate one or more alert signal indicative of one or more abnormal operation conditions, adjust one or more parameters of the power system, or modify the network topology of the power system.

According to another aspect, a method for power system state estimation can comprise acquiring, by a computer system, from remote terminal units, measurement data of a plurality of parameters of a power system, acquiring, by the computer system, network topology data of the power system, and determining, by the computer system, estimates of a plurality of states of the power system using the measurement data, the network topology data and a semidefinite relaxation formulation. The semidefinite relaxation formulation can include a convex lower bound approximation of a rank function of an augmented state matrix.

In some implementations, the one or more processors can be configured to acquire the measurement data in real time or near real time.

In some implementations, the plurality of parameters of the power system can include at least one of one or more active power flow parameters, one or more reactive power flow parameters, one or more power injection parameters, one or more voltage magnitude parameters, one or more voltage phase parameters, one or more current magnitude parameters, or one or more current phase parameters.

In some implementations, the plurality of states of the power system can include voltage magnitudes and voltages phases of a plurality of buses of the power system.

In some implementations, the convex lower bound approximation can be based on a convex envelope of the rank function of the augmented state matrix. The convex envelope can be defined in terms of a nuclear norm and 2-norm of the augmented state matrix.

In some implementations, the semidefinite relaxation formulation is convex.

In some implementations, the semidefinite relaxation formulation can include one or more constraints that are linearly related to the plurality of states of the power system. The one or more constraints including at least one of an equality constraint related to voltage parameters of the power system, an equality constraint related to current parameters of the power system, an equality constraint related phase parameters of the power system, or an equality constraint related to line admittance parameters of the power system.

In some implementations, the network topology data can include one or more states of one or more circuit breakers or circuit switches.

In some implementations, the method can comprise determining, by the computer system, based on the estimates of the plurality of states of the power system, whether the power system is operating normal operation conditions.

In some implementations, the method can comprise, upon determining that the power system is not operating in normal operation conditions, at least one of generating one or more alert signal indicative of one or more abnormal operation conditions, adjusting one or more parameters of the power system, or modifying the network topology of the power system.

Various refinements exist of the features noted in relation to the above-mentioned aspects. Further features may also be incorporated in the above-mentioned aspects as well. These refinements and additional features may exist individually or in any combination. For instance, various features discussed below in relation to any of the illustrated examples may be incorporated into any of the above-described aspects, alone or in any combination.

BRIEF DESCRIPTION OF DRAWINGS

The following drawings form part of the present specification and are included to further demonstrate certain aspects of the present disclosure. The disclosure may be better understood by reference to one or more of these drawings in combination with the detailed description of specific embodiments presented herein.

FIG. 1 is a block diagram of a power system, according to an example embodiment of the current disclosure.

FIG. 2 is a block diagram of a system for estimating and using power system states, according to an example embodiment of the current disclosure.

FIG. 3 is a block diagram of an example computer system that can be used to implement methods, systems and/or system components described herein.

FIG. 4. is a flow chart of a method for state estimation, according to an example embodiment of the current disclosure.

FIGS. 5A and 5B depict simulation results illustrating non-convergence of a method based on a non-convex SE problem formulation with FIG. 5A showing the mean absolute error between actual and estimated voltages and FIG. 5B showing the mean absolute error between and estimated voltage phases..

FIGS. 6A and 6B depict a 3-bus system model 600A and a corresponding two-port $\pi$-model of network branches 600B, respectively, according to an example embodiment of the current disclosure.

Corresponding reference characters indicate corresponding parts throughout the several views of the drawings. Although specific features of various examples may be shown in some drawings and not in others, this is for convenience only. Any feature of any drawing may be referenced or claimed in combination with any feature of any other drawing.

DETAILED DESCRIPTION

The following detailed description and examples set forth preferred materials, components, and procedures used in accordance with the present disclosure. This description and these examples, however, are provided by way of illustration only, and nothing therein shall be deemed to be a limitation upon the overall scope of the present disclosure. The following terms are used in the present disclosure as defined below.

State estimation (SE) in power systems, or power networks, is an important task that allows power networks or corresponding control systems to monitor accurately the underlying system state(s). Estimated or determined states of a power system can be used in various energy management system (EMS) application functions, such as the contingency analysis, automatic generation control, load forecasting and optimal power flow. For instance, estimated states of the power system allow for situational awareness by providing operators with a clear understanding of the current state of the power system enabling them to identify potential problems and take corrective actions. The estimated states can allow for stable and reliable control center operations when used in functions such as load flow analysis, contingency analysis, and power flow optimization. The estimated states can be used to assess the vulnerability of the power system to disturbances and potential cascading failures. The estimated states can enable efficient allocation of generation resources to meet demand while minimizing costs.

To estimate power system states, the control center or the system thereof can collect or acquire, e.g., via a set of sensors, measurements such as line power flows, bus voltage magnitudes, line current magnitudes, generator outputs, loads, circuit breaker and switch status information, transformer tap positions, and/or switchable capacitor bank values. The control center or the system thereof can process the measurements and/or raw data in order to filter the measurement noise and detect potential gross errors. The control center system can estimate the system power state(s) based on the available measurements and an assumed system model.

The electric power grid is typically a complex system including multiple subsystems. Each subsystem can include a transmission infrastructure spanning over a huge geographical area to transport energy from generators to distribution networks. Monitoring the operational conditions of the power system usually involves monitoring or measuring system variables at selected or defined nodes across the subsystems of the power grid. For instance, complex bus voltages at all buses in the power grid can be monitored or measured to be used in state estimation. The dimension of the measurement vector as well as the dimension of the state vector usually increase with the size of the power grid and/or the number of subsystems of the power grid. The increase in the dimensionality of the measurement and state vectors increases the complexity of the power system state estimation.

Furthermore, measured parameters are nonlinearly related to state variables. The nonlinearity makes the power system state estimation (SE) problem inherently nonconvex giving rise to many local optima. Specifically, SE amounts to solving a nonlinear (weighted) least-squares (LS) problem, e.g., using the iterative Gauss-Newton algorithm. Since the Gauss-Newton algorithm is a gradient descent based approach, it inevitably faces convergence issues and sensitivity to initialization especially when used to solve a non-convex problem. Without guaranteed convergence to the global optimum, existing variants have asserted numerical stability or robustness to outliers, but they can only improve the linearized error cost per iteration.

In addition, availability of suitable initializations becomes increasingly difficult with the penetration of renewable energy sources. The reason is two-fold. First, the intermittency of renewable energy sources leads to growing dynamics of the power system states. Given the dynamic nature of the system state(s), usage of temporal information to initialize the Gauss-Newton algorithm or any other gradient descent based iterative algorithm becomes less likely to lead to convergence. Also, emerging distributed energy resources (DERs) advocate the importance of SE for distribution networks, in which increased resistance-to-inductance ratios render voltage magnitudes non-flat. This is different from standard settings where flat voltage initializations are common for the linear DC flow approximation.

Other approaches for SE incorporate linear state measurements offered by synchronized phasor measurement units (PMUs) to develop the so-termed hybrid SE. However, limited PMU deployment currently confines SE to mostly rely on the nonlinear legacy meter measurements, and its companion Gauss-Newton iterative methods. Also, distributed SE among multiple control areas are strongly motivated by the deregulation of energy markets, where large amounts of power are transferred among areas over the tie-lines at increasing rates. However, most works on multi-area SE relies on linearized models or iteratively approximating to linear ones. Hence, with nonlinear (possibly along with linear) measurements, the grand challenge remains to develop solvers or distributed solvers approaching the global optimum at polynomial-time complexity.

In general, state estimation algorithms typically employ statistical methods, such as weighted least squares or maximum likelihood estimation, to account for measurement uncertainties and noise. Advanced techniques, such as incorporating phasor measurement unit (PMU) data, are increasingly being used to enhance the accuracy and speed of state estimation. However, these various techniques rely on a non-convex formulation of the SE problem.

Embodiments described herein introduce such polynomial-time SE algorithms for alternate current (AC) power systems, having the potential to attain a near-optimal state estimation. Given the non-convexity in SE problems, the proposed approaches leverage a well-appreciated optimization technique called semidefinite relaxation (SDR) that surrogates nonconvex problems by semidefinite programming (SDP) ones. In particular, embodiments herein describe a semidefinite programming (SDP) formulation for SE that involves convex SDR of the original problem and thereby renders the SE problem efficiently solvable. Theoretical analysis under simplified conditions is provided to shed light on the near-optimal performance of the SDR-based SE solution at polynomial complexity. The new approach is further pursued toward complementing traditional nonlinear measurements with linear synchrophasor measurements and reducing computational complexity through distributed implementations. Numerical tests on different IEEE bus system models corroborate that the new approach outperforms existing alternatives and approaches near-optimal performance.

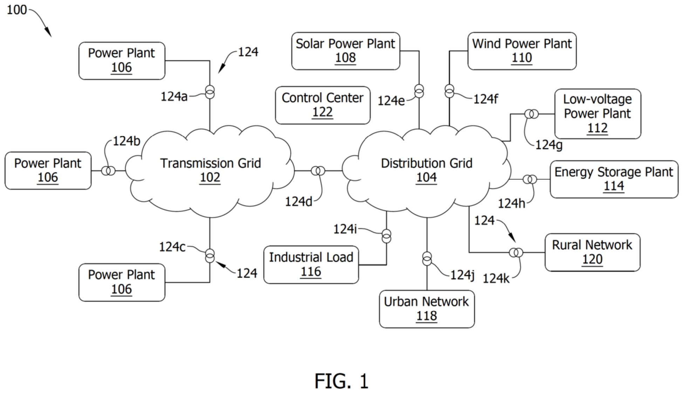

Referring now to FIG. 1, a diagram of a power system 100 is shown, according to an example embodiment of the current disclosure. At a high level, the power system 100 can include a plurality of a transmission grid 102, a distribution grid 104, one or more power plants 106 associated with the transmission grid 102, a solar power plant 108, a wind power plant 110, a low-voltage power plant 112, an energy storage plant 114, an industrial load 116, an urban network 118, a rural network 120, a control center 122, and a plurality of substations 124a-124k. The substations can be referred to herein, either individually or in combination, as substation(s) 124.

The one or more power plants 106 can include an extra high-voltage power plant, such as a coal plant, a nuclear plant and/or a hydro-electric plant. The one or more power plants 106 can include a high-voltage power plant, such as an industrial power plant and/or a medium-sized power plant. For instance, the transmission grid 102 can include an extra high voltage grid including or associated with one or more extra high voltage power plants, and a high voltage grid including or associated with one or more high-voltage power plants. The transmission grid can include or can be coupled to one or more substations 124, such as substations 124a-124c. Each of the substations 124a-124c can be associated with a corresponding power plant 106. Each of the substations 124a-124c can include a respective for transforming electric power generated by the corresponding power plant 106.

The distribution grid 104 can be connected or coupled to the transmission grid 102 via a substation 124d. The substation 124d can include a respective transformer to reduce the voltage of the electricity coming from the transmission grid 102. The distribution grid 104 can be associated with or coupled to (or can include) any combination of the solar power plant 108, wind power plant 110, low-voltage power plant 112, energy storage system 114, industrial load 116, urban network and/or rural network 120.

Renewable energy, such as the energy generated by the solar power plant 108 and/or the wind power plant 110, depends on weather conditions and may not be fully predictable. In particular, the amount of energy generated by the solar power plant 108 and/or the wind power plant 110 can dynamically change based on the weather conditions. The dynamic or unpredictable nature of the renewable energy contributes to time variability of the power system states and makes accurate and reliable state estimation even more important. In some implementations, the solar power plant 108 and/or the wind power plant 110 can be associated with, coupled to or part of the transmission grid 102, e.g., depending on the voltage of the respective generated electricity. The low-voltage power plant 112 include a relatively small coal, natural gas or hydroelectric plant configured to generate relatively low-voltage electric power, e.g., compared to the power plant(s) 160.

The energy storage plant 114 can include captured excess electric energy, e.g., during periods of low demand, and the excess electric energy in some other form. The stored energy can be converted back to electric energy to be distributed via the distribution grid 104 and consumed during periods of increased demand. The industrial load can include a manufacturing plant, factory, or industrial facility. The urban network 118 can include a network of houses, apartment buildings, office buildings, other types of buildings and/or street lights. The urban network 118 can include a network of houses, office buildings, other types of buildings, farms and/or street lights. The urban network 118 and/or the rural network 120 can include distributed solar panels that can inject electrical energy into the distribution grid.

The substations 124 act as transformers configured to reduce high-voltage electricity to a relatively lower voltage or transform direct current (DC) electricity to AC electricity. For example, the substations 124a-124c can transform the electric energy generated by the power plant(s) 106 to have a specific voltage for the transmission grid 102. The substation 124d can transform extra high-voltage or high-voltage electricity to lower-voltage electricity. The substation 124e can transform DC electricity to AC electricity. The substations 124f-124k can transform electricity to a lower-voltage.

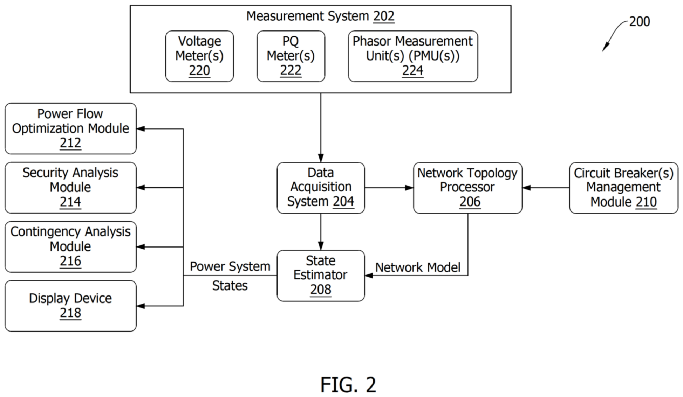

The control center 122 can include a system to manage, control and/or orchestrate electric power within the power system 100. For instance, the control center 122 can monitor, regulate, and optimize the flow of electrical power within the power system 100. The control center 122 or the system thereof can be coupled to a set of sensors arranged to measure parameter values at various nodes or points of the power system 100. The control center 122 or the system thereof can use measurements received from the sensors to manage or control the electric energy within the power system 100. Functions performed by the control center 122 are described in further detail in relation to FIG. 2 below.

FIG. 2 is a block diagram of a system 200 for estimating and using power system states, according to an example embodiment of the current disclosure. The system 200 can be a system of the control center 122. In brief overview, the system 200 can include a measurement system 202, a data acquisition system 204, a network topology processor 206, a state estimator 208, a circuit breaker(s) management module 210, a power flow optimization module, a security analysis module 214, a contingency analysis module 216, and a display device 218. The measurement system 202 can include one or more voltage meters 220, one or more power quality (PQ) meters 222, and one or more phasor measurement units (PMUs) 224.

The voltage meter(s) 220, the PQ meter(s) 222 and the PMU(s) 224 can be distributed or arranged at different points, nodes or locations of the power system 100. As an example, the voltage meters 220 and the PMUs 224 can be arranged or located at various buses or nodes of the power system 100 to measure complex voltages of the buses or nodes of the power system 100. The voltage meters 220 can measure voltage magnitudes of the buses while the PMUs 226 can measure the voltage phases of the buses. The PQ meters 222 can provide metering for current, voltage, real and reactive power, power factor and frequency. For instance, the PQ meters 22 can be arranged to measure line currents at various lines of the power system 100. In some implementations, one or more PMU(s) 226 can be arranged to measure current phases of lines of the power system 100. In general, the measurement system 202 can include a set of sensors or meters to measure parameter values of various parameters of the power system 100.

The data acquisition system 204 can receive measurements acquired by the voltage meter(s) 220, PQ meter(s) 222, PMU(s) 224 and/or other sensors of the measurement system 202 and provide the measurements to the state estimator 208. The data acquisition system 204 can provide one or more of the measurements received from the voltage meter(s) 220, PQ meter(s) 222, PMU(s) 224 and/or other sensors to the network topology processor 206. The data acquisition system 204 can include or can be a supervisory control and data acquisition (SCADA) system. The data acquisition system 204 can collect, analyze and display data from the voltage meter(s) 220, PQ meter(s) 222, PMU(s) 224 and/or other sensors.

The network topology processor 206 can receive data from the data acquisition system 204 and the circuit breaker(s) management module 210, and use the received data to determine or update a topology or network model of the power system 100. For instance, the network topology processor 206 can receive from the data acquisition system 204 voltage and/or current measurements associated with various buses and/or lines of the power system 100. The network topology processor 206 can receive information indicative of states of circuit breakers or switches of the power system 100 from the circuit breaker(s) management module 21. The data received from the data acquisition system 204 and the circuit breaker(s) management module 210 can be real-time data or near real-time data (e.g., with a delay less than or equal to few seconds relative to the time at which the data was measured or determined by the corresponding sensor(s) or the circuit breaker(s) management module 210. In some implementations, the circuit breaker(s) management module 210 can be configured to control the circuit breakers or switches of the power system 100.

The network model can include or can be a representation of the power system 100 depicting respective, e.g., power plants or generators, substations 124 or transformers, and/or loads as interconnected nodes where connections between nodes represent electric lines, e.g., transmission and/or distribution lines, of the power system 100. The network topology processor 206 can be configured to update the network model in real-time or near real-time, and provide an indication of the network model or updates thereof to the state estimator 208.

The state estimator 208 can receive measurements from the data acquisition system 204 and network model information from the network topology processor 206, and determine current states of the of the power system 100 using the received data. In particular, the state estimator 208 can determine a state vector indicative of a plurality of parameters or attributes of the power system 100 using the real-time (or near real-time) data received from the data acquisition system 204 and the network topology processor 206.

In some implementations, the data acquisition system 204 and/or the state estimator 208 can preprocess the measurements received from the voltage meter(s) 220, PQ meter(s) 222, PMU(s) 224 and/or other sensors. For example, the data acquisition system 204 and/or the state estimator 208 can filter the measurement noise and/or detect potential gross errors. Filtering the noise can include applying a whitening filter to measurements or measurement vectors received from the data acquisition system 204. If a gross error is detected, the corresponding measurement(s) or measurement vector(s) may be ignored and not used for state estimation.

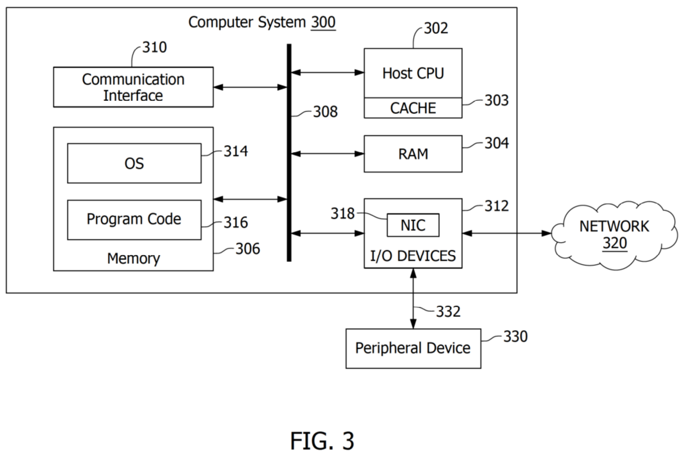

The state vector can include one or more complex voltage parameters, one or more complex current parameters, one or more power parameters or a combination thereof. A more detailed description of how the state estimator 208 determines or estimates the states or state vector of the power system 100 is provided below in relation to FIG. 3.

Once the current states or state vector of the power system 100 is determined or estimated, the state estimator 208 can provide the states or state vector to at least one of the power flow optimization module 212, the security analysis module 214, the contingency analysis module 215 and/or the display device 218. For instance, the power flow optimization module 212 can use the current state vector to determine or optimize the loads, e.g., in megawatts, to be supplied at certain nodes or buses of the system 100 in a way to minimize cost. The security analysis module 214 can be configured to evaluate and assess, using the state vector(s) received from the state estimator 208, the ability of the power system 100 to withstand disruptions and maintain stable electricity supply under various potential fault scenarios. In other words, the security analysis module 214 can use the state vector(s) to determine how well the power system 100 can continue producing and/or distributing electricity even when facing unexpected challenges. The contingency analysis module 216 can be configured to simulate potential failures of the power system 100 or subsystems thereof using the state vector(s) received from the state estimator 208. In some implementations, the state estimator 208 can provide the estimated or determined state vector(s) to the display device 218 for display. The display device 218 and receive and display the measurements acquired by the data acquisition system 204, the network model generated by the network topology processor 206 and/or the state vector(s) generated by the state estimator 208.

Each of the modules or components 204 - 216 of the system 200 can be implemented as a hardware, firmware, software or a combination thereof. For instance, any of the components or modules 204 - 216 of the system 200 can be as software instructions that can be stored in a memory and executed by one or more processors. The components or modules 204 - 216 of the system 200 or any combination thereof can be implemented in a single computer device or separate computer devices. In some implementations, any of the components or modules 204 - 216 can be implemented in dedicated hardware such as, for example, an application specific integrated circuit (ASIC), field programmable gate array (FPGA), or microprocessor, or implemented as executable software modules, or firmware, written to memory and executed on one or more processors.

FIG. 3 is a block diagram of an example computer system 300 that can be used to implement methods, systems and/or system components described herein. The computer system 300 can include a processor or central processing unit (CPU) 302, a cache memory 303, a random access memory (RAM) 304, a memory 306, a memory bus 308, a communication interface 310 and one or more input/output (I/O) devices 312. The processor 302 can include or can be coupled to the cache memory 303. The processor 302 can be coupled to the RAM 304 and the memory 306 via the memory bus 308. The cache memory 303 and the RAM 304 can be configured to operate in combination with the processor 302. The memory 306 can be a computer-readable memory (e.g., volatile, or non-volatile) that includes at least a memory section storing an operating system (OS) 314 and a section storing a program code 316. The program code 316 can include one or more modules of the system 200 shown in FIG. 2. For example, the program code 316 can include software instructions implementing or corresponding to any of the components or modules 204 - 216.

In some implementations, one or more sections of the memory 306 may be omitted and the corresponding data may be stored remotely. For example, the program code 316 may be stored remotely on a server or mass-storage device and made available over network 320 to the processor 302. Sensors of the measurement system 202, e.g., voltage meter(s) 220, PQ meter(s) and/or PMU(s) 224, can be coupled to the data acquisition system 204 via the network 320. The network 320 can include a wired communication network, a wireless communication network, Wi-Fi, a wide area network, a local area network, or a combination thereof.

The I/O device(s) 312 can include a communication interface such as a network interface controller (NIC) 318, or a peripheral interface for communicating with one or more peripheral devices 330 over a peripheral link 332. The I/O device(s) 330 can include, for example, the display device 218, one or more controllers of the measurement system 202 for controlling the voltage meter(s) 220, the PQ meter(s) 222, the PMU(s) 224 and/or other sensors, among other peripheral devices.

In some implementations, the computer system 300 can include multiple processors 302, e.g., with corresponding cache memories 303, multiple RAMs 304, multiple memories 306, multiple memory busses 308 and/or multiple communication interfaces 310. In some implementations, multiple interconnected computer systems 300 can used to implement the system 200 or components thereof. In some implementations, the computer system(s) 300 can be installed or integrated in the control center 122. In some implementations, one or more components of the control center 122 or the system 200 can be implemented in the cloud and can be coupled to the control center 122 or the computer system 300 via the network 320.

Embodiments described herein introduce a polynomial-time SE approach for AC power systems, such as power system 100. The SE approach has the potential to attain a near-optimal state(s) estimate. Given the non-convexity of the SE problem, the proposed approach leverages semidefinite relaxation (SDR) that surrogates nonconvex problems by semidefinite programming (SDP) ones.

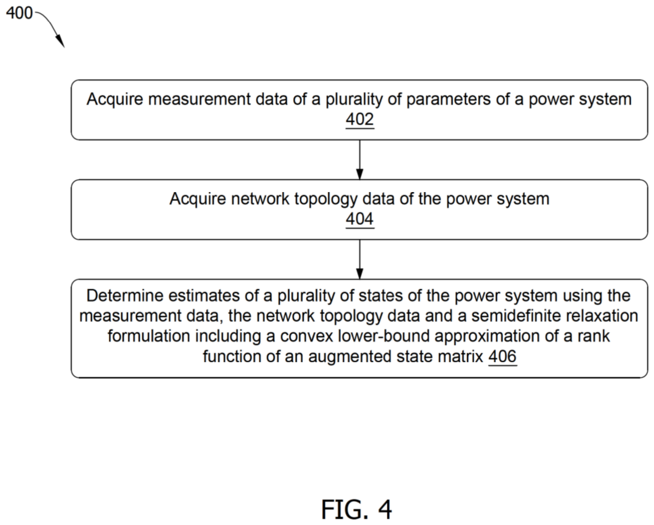

Referring now to FIG. 4, a flowchart depicting a method 400 for state estimation is shown, according to an example embodiment of the current disclosure. In brief overview, the method 400 can include acquiring measurement data of a plurality of parameters of a power system (402), acquiring network topology data of the power system (404), and determining estimates of a plurality of states of the power system using the measurement data, the network topology data, and a semidefinite relaxation formulation including a convex lower-bound approximation of a rank function of an augmented state matrix (406). The method 400 can, at least partially, be implemented or executed by the state estimator 208. The method 400 can be implemented using hardware, firmware, software or a combination thereof. For example, the method 400 can be implemented as software instructions of the program code 316 that are executable by processor 302.

The method 400 can include the state estimator 208 or the processor(s) 302 acquiring measurement data of a plurality of parameters of the power system 100 (402). As described above in relation to FIG. 2, sensors of the measurement system 202, e.g., voltage meter(s) 220, PQ meter(s) 222, PMU(s) 224 and/or other sensors, can measure values of various parameters of the power system 100. The measured parameters can include at least one of one or more active power flow parameters, one or more reactive power flow parameters, one or more power injection parameters, one or more voltage magnitude parameters, one or more voltage phase parameters, one or more current magnitude parameters, one or more current phase parameters, one or more power factor parameters, among others. The sensors of the measurement system 202 can be configured or controlled to measure corresponding parameter values on a continuous or periodic basis. For instance, the sensors can be configured with a measuring frequency according to which measurements are acquired.

The data acquisition system 204 can receive the measurements from the sensors of the measurement system 202, and provide them to the state estimator 208. The state estimator 208 and/or the processor(s) can acquire the measurement data in real time or near real time. For instance, parameter values measured by the sensors of the measurement system 202 can be transferred immediately with little or no delay, after acquisition by the sensors, to the state estimator 208 and/or the processor 302. Little delay of less than or equal to 0.1 second, 0.5 second, 1 second, 2 seconds or some other time threshold may be tolerated. The data acquisition system 204 can manage and coordinate collection of the measurements from the sensors and the transfer of the collected measurements to the state estimator 208 and/or the processor(s) 302.

The method 400 can include the state estimator 208 and/or the processor(s) 302 acquiring network topology data of the power system (404). The circuit breaker(s) management module 210 can be configured to manage, control and/or orchestrate the states of the circuit breakers (or switches) of the power system 100. Each time the status of a circuit breaker or switch changes, the circuit breaker(s) can report such change in real time or near real time to the network topology processor 206. The network topology processor 206 can use the information received from the circuit breaker(s) management module 210 and/or data received from the data acquisition system 204 to generate or update a network model of the power system 100. The network model or the network topology data can reflect current state(s) of one or more circuit breakers or circuit switches of the power system 100. The network topology processor 206 can provide information indicative of the current network model or updates to the network model to the state estimator 208.

The method 400 can include the state estimator 208 and/or the processor(s) 302 determining estimates of a plurality of states of the power system 100 using the measurement data, the network topology data, and a semidefinite relaxation formulation including a convex lower-bound approximation of a rank function of an augmented state matrix (406). The plurality of states of the power system 100 can include voltage magnitudes and voltages phases of a plurality of buses of the power system 100. More generally, the plurality of states or the state vector of the power system 100 can include one or more complex voltage parameters, one or more complex current parameters, one or more power parameters or a combination thereof. The plurality of states can be nonlinearly related to the measurement parameters for which the sensors of the measurement system 202 measures respective values on a continuous or periodic basis.

The state estimator 208 and/or the processor(s) 302 can employ a semidefinite relaxation (SDR) formulation to solve the SE problem. As illustrated in further detail below, the semidefinite relaxation formulation transforms the SE problem to a convex problem. In particular, the SE problem is typically formulated as a nonlinear and nonconvex least squares (LS), or nonlinear and nonconvex maximum likelihood (ML), formulation. According to example embodiments described herein, SDR and a convex lower-bound approximation of a rank function of an augmented state matrix can be used to transform and/or relax the nonlinear and nonconvex ML formulation to a convex SDR formulation.

In the following, a mathematical derivation of the convex SDR formulation is described. While the mathematical derivation is shown for an example measurement vector and an example state vector, a person skilled in the relevant art would recognize that convex SDR formulations can be generated or derived for other measurement vectors and/or other state vectors. In particular, in the following derivation, the state vector is defined as a vector of complex voltages of a plurality of buses of the power system 100. However, a convex SDR formulation of the SE problem can be derived, in a similar way, for other state vectors. For example, the state vector can include one or more complex voltages of one or more buses and/or one or more complex currents of one or more lines of the power system 100.

Consider a power network, e.g., power system 100, with buses denoted by the set $\mathcal{N} := \{1, \ldots, N\}$, and all lines represented by $\varepsilon := \{(n, m)\}$. To estimate a complex voltage $V_n$ of bus $n \in \mathcal{N}$, the measurement system 202 or sensors thereof can measure a subset of the variables $P_n(Q_n)$ representing the real (reactive) power injection at bus $n$, $P_{mn}(Q_{mn})$ representing the real (reactive) power flow from bus $m$ to bus $n,$ and $|V_n|$ representing the voltage magnitude at bus $n$. It is to be noted that the real (reactive) power injection at bus $n$ and denoted as $P_n(Q_n)$ can be negative if bus $n$ is connected to a load. The state estimator 208 and/or the processor 302 can estimate the complex voltage $V_n$ of bus $n$ in a rectangular coordinate, as opposed to a polar coordinate system which is usually the case for existing state estimation approaches. In some implementations, the measurement system 202 or sensors thereof can measure values of other parameters of the power system 100, e.g., depending on the state vector to be estimated or determined.

Compliant with the AC power flow model, these measurements are nonlinearly related with the system states, e.g., the vector $\mathbf{v} := [v_1, \ldots, v_N]^T \in C^N$. In particular, let the injected currents of all buses be represented in the current vector $\mathbf{I} := [I_1, \ldots, I_N]^T \in C^N$, and let $\mathbf{Y} \in C^{\{N \times N\}}$ represent the bus admittance matrix, Kirchhoff's law in vector-matrix form implies that $\mathbf{i} = \mathbf{Yv}$, where the $(m, n)$-th entry of the admittance matrix Y is:

$$Y_{mn} := \begin{cases} -y_{mn}, & if\ (m,n) \in \mathcal{E} \\ \bar{y}_{nn} + \sum_{v \in \mathcal{N}_n} y_{nv}, & if\ m = n\ , \\ 0, & otherwise \end{cases} \quad (1)$$

where $y_{mn}$ denotes the line admittance between buses $m$ and $n$, $\bar{y}_{nn}$ denotes the shunt admittance of bus $n$ to the ground, and $\mathcal{N}_n$ represents the set of all buses linked to the bus $n$ via transmission lines.

Let the measurement vector z be defined as:

$$\mathbf{z} := \left[ \{\hat{P}_n\}_{n \in \mathcal{N}_P}, \{\hat{Q}_n\}_{n \in \mathcal{N}_Q}, \{\hat{P}_{mn}\}_{(m,n) \in \mathcal{E}_P}, \{\hat{Q}_{mn}\}_{(m,n) \in \mathcal{E}_Q}, \{|\hat{v}_n|^2\}_{n \in \mathcal{N}_v} \right]^T. \quad (2)$$

In some implementations, the measurement system 202, the data acquisition system 204 or the state estimator 208 can pre-whiten the measurement vector **z** so that all error terms have uniform variance. The maximum likelihood (ML) formulation for estimating the state vector **v** can be described as:

$$\hat{\mathbf{v}} = arg \min_{\mathbf{v}} \sum_{l=1}^{L} \left[ z_l - h_l(\mathbf{v}) \right]^2. \quad (3)$$

Each function $h_l(\mathbf{v})$ can be a nonlinear function defining a nonlinear functional relationship between the state vector v and the measurement parameter $z_l$. The functions $h_l(\mathbf{v})$ can depend on the current network model of the power system 100. In practice, each measurement value $z_l$ can be described as $z_l = h_l(\mathbf{v}) + e_l$, where $e_l$ is noise value or a measurement error.

The ML formulation in equation (3) is a nonconvex least-squares formulation. The Gauss-Newton iterative solver for nonlinear LS problems has been widely used for SE. Using Taylor's expansion around a given starting point, the pure form of Gauss-Newton methods approximates the cost function in equation (3) with a linear LS one, and relies on its minimizer to initialize the subsequent iteration. This iterative procedure is closely related to gradient descent algorithms for solving nonconvex problems, which are known to encounter or be prone to two issues, sensitivity to the initial guess and likelihood of non-convergence.

Typical Gauss-Newton iterations for SE start with a flat voltage profile, where all bus voltages are initialized with the same real number. Unfortunately, this fails to guarantee convergence to the global optimum, as pointed out early. Existing variants have asserted improved numerical stability and robustness to outliers, but they are all limited to improving the approximate error cost per iteration. Recently, with the advent of PMU technology, SE has benefited greatly by including synchrophasor data, which adhere to linear measurement models with respect to the unknown v. Unfortunately, cost and limited penetration of PMUs require linear measurements to be combined with nonlinear ones to ensure observability.

The main challenge with solving the SE problem is to develop a solver or an SE formulation attaining or approximating the global optimum at polynomial-time complexity. In the following, this challenge is addressed by appropriately reformulating the SE problem to apply the semidefinite relaxation (SDR) technique.

The SE problem of equation (3) can be reformulated as:

$$\{\hat{\mathbf{V}}, \hat{\mathbf{v}}, \hat{\mathbf{x}}\} = arg \min_{\mathbf{V}, \mathbf{v}, \mathbf{x}} \mathbf{w}^T \mathbf{x},$$

$$s.t. \quad \mathbf{V} = \mathbf{v}.\mathbf{v}^H,$$

$$\begin{bmatrix} -x_l & z_l - Tr(\mathbf{H}_l\mathbf{V}) \\ z_l - Tr(\mathbf{H}_l\mathbf{V}) & -1 \end{bmatrix} \preccurlyeq 0 \quad \forall l. \quad (4)$$

The matrix $\mathbf{H}_l$ is defined based on or using the nonlinear function $h_l$. The SE problem as described in equation (4) is a nonconvex problem due to the nonlinear equality constraint $\mathbf{V} = \mathbf{v}.\mathbf{v}^H$. The non-convexity implies that the problem formulation (4) has multiple local optima.

Various methods can be used to relax the nonconvex problem (4) to a corresponding convex problem. A first approach would be to replace the nonlinear equality constraint of $\mathbf{V} = \mathbf{v}.\mathbf{v}^H$ with a positive semidefinite constraint and a rank constraint for the matrix $\mathbf{V}$ leading to the SE problem formulation:

$$\{\hat{\mathbf{V}}, \hat{\mathbf{x}}\} = arg \min_{\mathbf{V}, \mathbf{x}} \mathbf{w}^T \mathbf{x},$$

$$s.t. \ \mathbf{V} \succcurlyeq \mathbf{0},$$

$$rank(\mathbf{V}) = 1,$$

$$\begin{bmatrix} -x_l & z_l - Tr(\mathbf{H}_l\mathbf{V}) \\ z_l - Tr(\mathbf{H}_l\mathbf{V}) & -1 \end{bmatrix} \preccurlyeq \mathbf{0} \quad \forall l. \quad (5)$$

Dropping the rank constraint in the problem formulation (5) leads to the relaxation problem:

$$\{\hat{\mathbf{V}}, \hat{\mathbf{x}}\} = arg \min_{\mathbf{V}, \mathbf{x}} \mathbf{w}^T \mathbf{x},$$

$$s.t. \ \mathbf{V} \succcurlyeq \mathbf{0},$$

$$\begin{bmatrix} -x_l & z_l - Tr(\mathbf{H}_l\mathbf{V}) \\ z_l - Tr(\mathbf{H}_l\mathbf{V}) & -1 \end{bmatrix} \preccurlyeq \mathbf{0} \quad \forall l. \quad (6)$$

According to a second approach, the nonlinear equality constraint of $\mathbf{V} = \mathbf{v}.\mathbf{v}^H$ can be replaced with a semidefinite relaxation constraint for an augmented state matrix resulting in:

$$\{\hat{\mathbf{V}}, \hat{\mathbf{v}}, \hat{\mathbf{x}}\} = arg \min_{\mathbf{V}, \mathbf{v}, \mathbf{x}} \mathbf{w}^T \mathbf{x},$$

$$s.t. \ \mathbf{V} \succcurlyeq \mathbf{0},$$

$$\begin{bmatrix} \mathbf{V} & \mathbf{v} \\ \mathbf{v}^H & 1 \end{bmatrix} \succcurlyeq \mathbf{0},$$

$$\begin{bmatrix} -x_l & z_l - Tr(\mathbf{H}_l\mathbf{V}) \\ z_l - Tr(\mathbf{H}_l\mathbf{V}) & -1 \end{bmatrix} \preccurlyeq \mathbf{0} \quad \forall l. \quad (6\text{-}1)$$

The matrix $\begin{bmatrix} \mathbf{V} & \mathbf{v} \\ \mathbf{v}^H & 1 \end{bmatrix}$ is the augmented state matrix that can be generated from the state vector $\mathbf{v}$. The semidefinite relaxation constraint implies that the augmented state matrix is a positive semidefinite matrix.

The first method or approach represented by the formulation (6) does not guarantee that the matrix $\mathbf{V}$ has rank equal to 1. Hence, to enforce a low-rank property for the matrix $\mathbf{V}$, the cost function in the SE formulation (6) can be augmented with a second nuclear norm term leading to a third approach or method described as:

$$\{\hat{\mathbf{V}}, \hat{\mathbf{x}}\} = arg \min_{\mathbf{V}, \mathbf{x}} \mathbf{w}^T \mathbf{x} + \lambda \|\mathbf{V}\|_*,$$

$$s.t. \ \mathbf{V} \succcurlyeq \mathbf{0},$$

$$\begin{bmatrix} -x_l & z_l - Tr(\mathbf{H}_l\mathbf{V}) \\ z_l - Tr(\mathbf{H}_l\mathbf{V}) & -1 \end{bmatrix} \preccurlyeq \mathbf{0} \quad \forall l. \quad (7)$$

The operator $\|\|\|_*$, refers to the nuclear norm, and $\lambda$ is a Lagrange multiplier.

None of the methods or approaches corresponding to the formulations (5) and (6) provides a proper relaxation of the original SE problem described in the formulation (4). More importantly, they cannot handle any constraint that is linearly dependent on the voltage variable v, as it only captured in quadratic form in **V** but not in linear form. Although method 2 can handle constraints that are linearly dependent on the voltage variable **v,** it does not provide the tightest convex envelope for the rank function. In the following, we aim to introduce a better relaxation of (4).

According to a mathematical Lemma, the rank of a Hermitian block matrix is equal to the rank of a diagonal block plus the rank of its Schur complement. In other words, if C is invertible, then

$$\text{rank}\left(\begin{bmatrix} \mathbf{A} & \mathbf{B} \\ \mathbf{B}^{\mathbf{H}} & \mathbf{C} \end{bmatrix}\right) = \text{rank}(\mathbf{C}) + rank(\mathbf{A} - \mathbf{B}\mathbf{C}^{-1}\mathbf{B}^{\mathbf{H}}). \quad (8)$$

Using this Lemma, the constraint **V** = **v.v**$^H$ is equivalent to or can be replaced with:

$$\mathbf{V} = \mathbf{v}.\mathbf{v}^H \Longleftrightarrow \text{rank}\left(\mathbf{V} - \mathbf{v}.\mathbf{v}^H\right) = 0$$

$$\Longleftrightarrow 1 + \text{ rank}\left(\mathbf{V} - \mathbf{v}.\mathbf{v}^H\right) = 1$$

$$\Longleftrightarrow \text{rank}\left(\begin{bmatrix} \mathbf{V} & \mathbf{v} \\ \mathbf{v}^H & 1 \end{bmatrix}\right) = 1. \quad (9)$$

Using equation (9), the SE problem formulation (4) can be transformed to

$$\left\{\hat{\mathbf{V}}, \hat{\mathbf{v}}, \hat{\mathbf{x}}\right\} = arg \min_{\mathbf{V},\mathbf{v},\mathbf{x}} \mathbf{w}^T \mathbf{x},$$

$$s.t. \ \mathbf{V} \succcurlyeq \mathbf{0},$$

$$\text{rank}\left(\begin{bmatrix} \mathbf{V} & \mathbf{v} \\ \mathbf{v}^H & 1 \end{bmatrix}\right) = 1,$$

$$\begin{bmatrix} -x_l & z_l - Tr(\mathbf{H}_l\mathbf{V}) \\ z_l - Tr(\mathbf{H}_l\mathbf{V}) & -1 \end{bmatrix} \preccurlyeq \mathbf{0} \quad \forall l. \quad (10)$$

To relax the formulation (10) to a corresponding convex formulation, the formulation (10) can be replaced with:

$$\left\{\hat{\mathbf{V}}, \hat{\mathbf{v}}, \hat{\mathbf{x}}\right\} = arg \min_{\mathbf{V},\mathbf{v},\mathbf{x}} \mathbf{w}^T \mathbf{x} + \lambda \left\|\begin{bmatrix} \mathbf{V} & \mathbf{v} \\ \mathbf{v}^H & 1 \end{bmatrix}\right\|_*,$$

$$s.t. \ \mathbf{V} \succcurlyeq \mathbf{0},$$

$$\begin{bmatrix} -x_l & z_l - Tr(\mathbf{H}_l\mathbf{V}) \\ z_l - Tr(\mathbf{H}_l\mathbf{V}) & -1 \end{bmatrix} \preccurlyeq \mathbf{0} \quad \forall l. \quad (11)$$

According to a mathematical theorem, on a set S = {$\mathbf{X} \in$ R{$^{m \times n}$} | $\|\mathbf{X}\|_2 \leq$ M}, the convex envelope of the function rank(**X**) is 1/M$\|\mathbf{X}\|_*$. Hence, rank(**X**)$\geq$ 1/M$\|\mathbf{X}\|_*$ for all **X** $\in$ S. In other words, by solving the heuristic problem, one can obtain a lower bound on the optimal value of the original problem provided that a bound M on the feasible set is identified. Note that the nuclear norm is the tightest convex lower approximation to the rank function over the set S. Thus, among all convex approximations, it yields the tightest global lower bound for the rank function. Given that matrix norm-2 is always less than or equal to the Frobenius norm with the equality holding for a matrix with a rank equal to 1. Hence, the lower bound M can be defined as:

$$M = \left\| \begin{bmatrix} \mathbf{V} & \mathbf{v} \\ \mathbf{v}^H & 1 \end{bmatrix} \right\|_2 = \left\| \begin{bmatrix} \mathbf{V} & \mathbf{v} \\ \mathbf{v}^H & 1 \end{bmatrix} \right\|_F = \left( Tr \left( \begin{bmatrix} \mathbf{V}^2 + \mathbf{V} & \mathbf{V}\mathbf{v} + \mathbf{v} \\ \mathbf{v}^H \mathbf{V} + \mathbf{v}^H & \mathbf{v}^H \mathbf{v} + 1 \end{bmatrix} \right) \right)^{\frac{1}{2}}$$

$$= \left[ Tr(\mathbf{V}^2) + Tr(\mathbf{V}) + \mathbf{v}^H \mathbf{v} + 1 \right]^{\frac{1}{2}}$$

$$= \left[ Tr(\mathbf{v}\mathbf{v}^H \mathbf{v}\mathbf{v}^H) + Tr(\mathbf{v}\mathbf{v}^H) + \mathbf{v}^H \mathbf{v} + 1 \right]^{\frac{1}{2}}$$

$$= \left[ Tr(\mathbf{v}^H \mathbf{v}\mathbf{v}^H \mathbf{v}) + Tr(\mathbf{v}^H \mathbf{v}) + \mathbf{v}^H \mathbf{v} + 1 \right]^{\frac{1}{2}}$$

$$= \left[ (\mathbf{v}^H \mathbf{v})^2 + 2\mathbf{v}^H \mathbf{v} + 1 \right]^{\frac{1}{2}}$$

$$= \mathbf{v}^H \mathbf{v} + 1$$

$$= Tr(\mathbf{v}^H \mathbf{v}) + 1$$

$$= Tr(\mathbf{V}) + 1$$

$$= Tr \left( \begin{bmatrix} \mathbf{V} & \mathbf{v} \\ \mathbf{v}^H & 1 \end{bmatrix} \right)$$

$$= \sum_{i=1}^N |v_i|^2 + 1$$

$$\approx N + 1. \qquad (12)$$

The last approximation in equation (12) is based on the fact that all bus voltages $|v_i|$ are close to 1 per-unit (pu).

By replacing the regularization $\lambda$ with 1/M in the formulation (11), the SE problem formulation can be described as:

$$\{\hat{\mathbf{V}}, \hat{\mathbf{v}}, \hat{\mathbf{x}}\} = \arg \min_{\mathbf{V},\mathbf{v},\mathbf{x}} \mathbf{w}^T \mathbf{x} + \frac{1}{M} \left\| \begin{bmatrix} \mathbf{V} & \mathbf{v} \\ \mathbf{v}^H & 1 \end{bmatrix} \right\|_*,$$

$$s.t. \ \mathbf{V} \succcurlyeq \mathbf{0},$$

$$\begin{bmatrix} -x_l & z_l - Tr(\mathbf{H}_l \mathbf{V}) \\ z_l - Tr(\mathbf{H}_l \mathbf{V}) & -1 \end{bmatrix} \preccurlyeq \mathbf{0} \quad \forall l. \qquad (13)$$

As discussed above in relation to the stated mathematical theorem, $\text{rank}(\mathbf{X}) \geq 1/M \|\mathbf{X}\|_*$. Therefore, the rank constraint in the SE problem formulation (10) can be relaxed leading to:

$$\{\hat{\mathbf{V}}, \hat{\mathbf{v}}, \hat{\mathbf{x}}\} = \arg \min_{\mathbf{V},\mathbf{v},\mathbf{x}} \mathbf{w}^T \mathbf{x},$$

$$s.t. \ \mathbf{V} \succcurlyeq \mathbf{0},$$

$$\left\| \begin{bmatrix} \mathbf{V} & \mathbf{v} \\ \mathbf{v}^H & 1 \end{bmatrix} \right\|_* \leq M,$$

$$\begin{bmatrix} -x_l & z_l - Tr(\mathbf{H}_l \mathbf{V}) \\ z_l - Tr(\mathbf{H}_l \mathbf{V}) & -1 \end{bmatrix} \preccurlyeq \mathbf{0} \quad \forall l. \qquad (14)$$

The solution to the proposed relaxed SE problem formulations (13) and (14) is very likely to have rank greater than 1. Given an estimate $\hat{\mathbf{V}}$ of the matrix $\mathbf{V}$, an estimate $\hat{\mathbf{v}}$ of the state vector $\mathbf{v}$ can be derived or obtained from the matrix $\hat{\mathbf{V}}$. Considering the eigenvalue decomposition $\hat{\mathbf{V}} = \sum_{i=1}^r \lambda_i \boldsymbol{u}_i \boldsymbol{u}_i^H$, where $r = \text{rank}(\hat{\mathbf{V}})$, $\lambda_1 \geq \ldots \geq \lambda_r > 0$ denote the ordered eigenvalues of the matrix $\hat{\mathbf{V}}$, and $\{\boldsymbol{u}_i \in C^N\}_{i=1}^r$ are the corresponding eigenvectors, the best (in the minimum-norm sense) rank-one estimate of $\hat{\mathbf{V}}$ is equal to $\lambda_1 \boldsymbol{u}_1 \boldsymbol{u}_1^H$. Accordingly, the estimate of the state vector can be determined as

$\hat{\mathbf{v}} = \sqrt{\lambda_1}\boldsymbol{u}_1$ . Also note that:

$$\sum_{i=1}^{N} |v_i|^2 = \mathbf{v}^H\mathbf{v} = \lambda_1\boldsymbol{u}_1^H\boldsymbol{u}_1 = \lambda_1. \quad (15)$$

The proposed relaxed SE problem formulations (13) and (14) include the voltage vector, or more generally the state vector, in linear form. The voltage variables $v_i$ (or more generally state variables) can be used to model measurements or measured parameters that are linearly dependent on the voltage parameters $v_i$. In other words, the proposed formulations (13) and (14) allow incorporating additional constraints that are linearly dependent on state vector. The semidefinite relaxation formulation applied in method 400 can include one or more constraints that are linearly related to the plurality of states of the power system. The one or more constraints can include at least one of, an equality constraint related to voltage parameters of the power system 100 such as Kirchhoff s voltage law (KVL), an equality constraint related to current parameters of the power system 100 such as Kirchhoff s current law (KCL), an equality constraint related to phase parameters or PMU measurements of the power system 100 such as $v_i = a + jb$, or an equality constraint related to line admittance parameters of the power system 100 such **as $I$ = $Y.V$. It is** to be noted that such constraints cannot be incorporated in the formulations the formulations (5), (6) and (7) where the state vector does not appear in a linear form. While in the SE problem formulation (6-1) the state vector appears in linear form, this formulation does employ a tight approximation (or tightest lower bound) for the rank function.

The approximation value of M can be calculated according to equation (12), which is an approximation and not an exact value. As such, an iterative approach can used or performed around the value of M indicated in equation (12). In the iterative approach, the state estimator 208 and/or the processor(s) 302 can start by using a looser bound, such as M > N + 1, and solve the SDR problem (14) to find the next updated value of $M = \sum_{i=1}^{N} |v_i|^2 + 1$ . The state estimator 208 and/or the processor(s) 302 can repeat this process until the cost function

$$J = \sum_{l=1}^{L} \frac{1}{\sigma_i^2}\big[z_l - Tr(\mathbf{H}_l\mathbf{V})\big]^2 \quad (16)$$

no longer decreases or the change in the cost function is less than a defined threshold. Note that under normal grid operation conditions, all bus voltages are less than 1.1 pu, i.e., $|v_i| < 1.1$ for all $i$. An example starting point for M can be

$$M = \sum_{i=1}^{N} |v_i|^2 + 1 \leq 1.21N + 1. \quad (17)$$

Therefore, the state estimator 208 and/or the processor(s) 302 can determine the state vector (402) according to the following algorithm outlining the iterative process for finding the optimal value of M.

| **Algorithm 1:** *Finding the Optimal Value of M* |
|---|
| *Initialize: M = 1.21N + 1* |
| *Solve (14) to find Tr(**V**) +1 and cost function J as in (16)* |
| ***repeat*** |
|     *M ← Tr(V) +1* |
|     *Solve (14) to find Tr(**V**) +1 and cost function J as in (16)* |
| ***until** a stopping condition is achieved* |

The stopping condition can include the cost function J is no loger decreasing and/or the decrease is less than a defined threshold. The state estimator 208 and/or the processor 302 can use the last value of $\hat{\mathbf{v}}$, e.g., obtained by solving the SE problem formulation (14) in the last iteration of the above algorithm, as the final estimate of the state vector.

In the SE problem formulation (14), the convex lower bound M (or the corresponding approximation N+1) for the rank of the augmented state matrix, is based on a convex envelope of the rank function of the augmented state matrix. As discussed above the convex envelope is defined in terms of a nuclear norm of the augmented state matrix and can be viewed as the tightest mathematical approximation or lower bound for the rank function.

As discussed above in relation with FIG. 2, the state estimator 208 and/or the processor(s) 302 can provide the estimated state vector $\hat{\mathbf{v}}$ to the power flow optimization module 212, the security analysis module 214, the contingency analysis module 216 and/or the display device 218. The power flow optimization module 212 can use the current state vector to adjust, change or optimize the load(s) to be supplied at one or more nodes or buses of the power system 100 in a way to minimize or reduce cost. The security analysis module 214 can use the state vector(s) to determine how well the power system 100 can continue producing and/or distributing electricity even when facing unexpected challenges. The contingency analysis module 216 can be configured to simulate potential failures of the power system 100 or subsystems thereof using the state vector received from the state estimator 208. The display device 218 can display the state vector for operators of the power system 100.

In some implementations, the state estimator 208 and/or the processor(s) 302 can determine, based on the estimated state vector $\hat{v}$, whether the power system 100 is operating in normal operation conditions. The processor(s) 302 can determine whether the power system 100 is operating in normal operation conditions based on analysis performed by the power flow optimization module 212, the security analysis module 214 and/or the contingency analysis module 216. For example, the processor(s) 302 can determine that the power system 100 is not operating in normal conditions responsive to the security analysis module 214 determining that power system 100 at its current state is likely to fail in the case of a potential challenge or change. The processor(s) 302 can determine that power system 100 is not operating in normal conditions responsive to determining that one or more state values are exceeding one or more corresponding thresholds. The processor(s) 302 can determine whether or not the power system 100 is operating in normal conditions by applying a defined rule to the estimated state vector or by using a trained machine learning model that receives the estimated state vector as input

In some implementations, the processor(s) can, upon determining that the power system is not operating in normal operation conditions, perform at least one of generating one or more alert signals indicative of one or more abnormal operation conditions, e.g., to be displayed to the operators on the display device 218, adjusting one or more parameters of the power system 100, or modify the network topology of the power system 100. For example, the processor(s) 302 can cause one or more circuit breakers to be closed or open. The processor(s) 302 and/or the power flow optimization module 212 can adjust one or more power flows upon determining that the power system 100 is not operating in a cost efficient way. The processor(s) 302 can cause power flow to be directed to the energy storage plant 114 upon determining that demand is lower than the generated electricity.

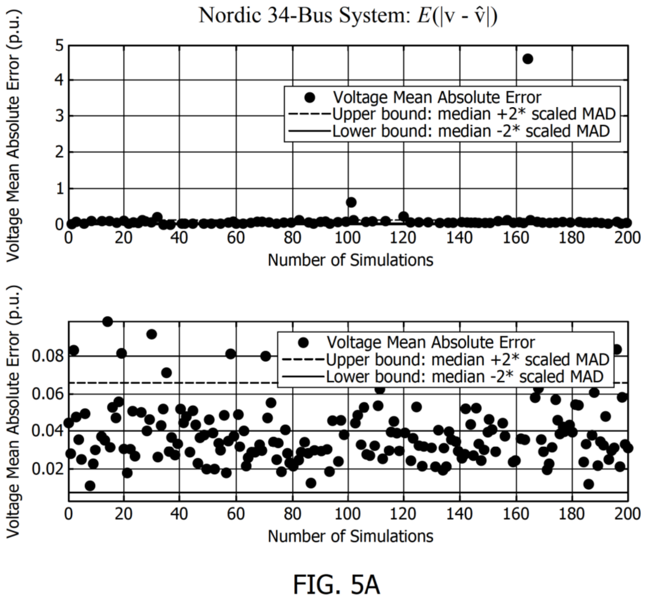

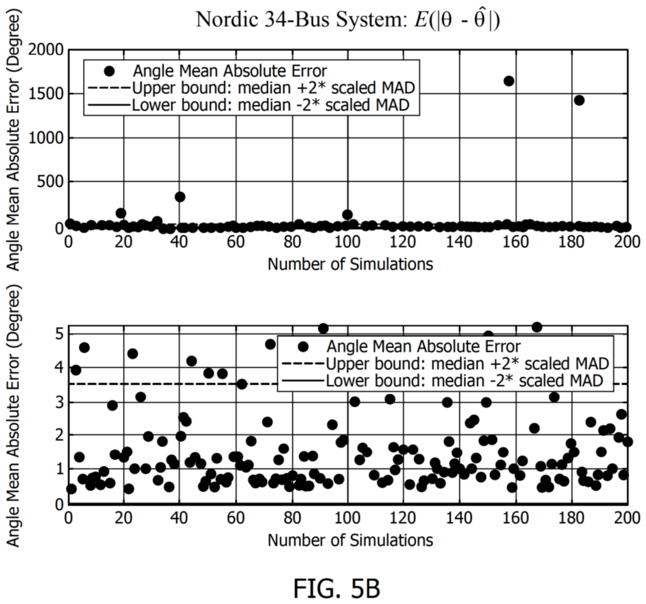

FIGS. 5A and 5B depict simulation results illustrating non-convergence of a method based on a non-convex SE problem formulation. FIG. 5A depicts the mean absolute error between actual and estimated voltages. FIG. 5B depicts the mean absolute error between and estimated voltage phases. In both figures, convergence is achieved if the mean absolute error is between the corresponding upper bound and lower bound lines.

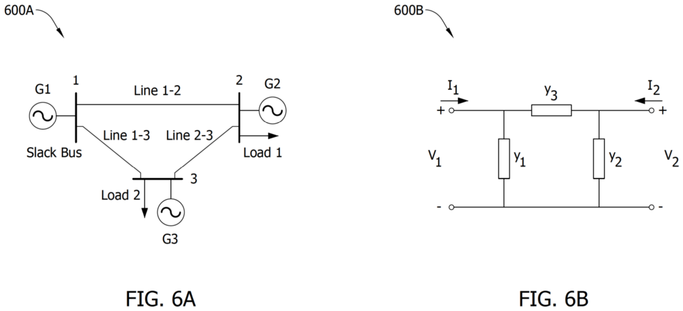

FIGS. 6A and 6B depict a 3-bus system model 600A and a corresponding two-port $\pi$-model of network branches 600B, respectively, according to an example embodiment of the current disclosure. The state vector of the power system of FIGS. 6A and 6B is estimated using three different methods. The first estimation method is based on solving the SE problem formulation (6), the second estimation methods is based on solving the SE problem formulation (6-1), and the third method is based on solving the SE problem formulation (14), e.g., using *Algorithm 1* above.

Table 1 below describes measurements of the 3-bus system model 600A and their standard deviations. The last two rows describe the states to be estimated, which are the voltages of buses 1 and 2. The first six rows describe the measured parameters to be used as the measurement vector.

Table 1. Measured values of 3-bus system model 600A of FIG. 6A.

| Measurement | Type | Value (per-unit) | Standard Deviation |
|---|---|---|---|
| 1 | P12 (active power flow from bus 1 to bus 2) | 1.8 | 0.008 |
| 2 | P13 (active power flow from bus 1 to bus 3) | 0.385 | 0.008 |
| 3 | P2 (active power injection at bus 2) | -3.975 | 0.010 |
| 4 | Q12 (reactive power flow from bus 1 to bus 2) | 1.18 | 0.008 |
| 5 | Q13 (reactive power flow from bus 1 to bus 3) | 0.225 | 0.008 |
| 6 | Q2 (reactive power injection at bus 2) | -2.505 | 0.010 |
| **7** | $v_1$ | **1.048** | **0.004** |
| **8** | $v_2$ | **0.97** | **0.004** |

Table 2 below depicts the estimation results using the three different relaxation techniques associated with the formulations (6), (6-1) and (14). From the results in Table 2, one can see that the SDR formulation (14) outperforms the other two techniques. For example the estimated values of $v_1$ and $v_2$ provided by the SDR approach corresponding to the SE problem formulation (14) is much closer to the actual values of $v_1$ and $v_2$ shown in Table 1 compared to the corresponding estimates provided by the other two techniques. Furthermore, the cost function of the SDR approach based on formulation (14) at convergence is much smaller than the cost function for the other two techniques. In addition, the eigenvalues of the estimated matrix **V** show that the SDR approach based on formulation (14) provides a state matrix with only one significant eigenvalue (good approximation of a rank-one matrix), whereas the state matrices for the other two techniques have two significant eigenvalues. Finally, the final value of M is very close to the number of buses plus 1. All these factors illustrate a better performance of the proposed approach based on the SE problem formulation (14).

Table 2. State estimation results for the 3-bus system model 600A based on 3 different relaxation techniques.

| Results | SDR based on (6) | SDR based on (6-1) | SDR based on (14) |
|---|---|---|---|
| $v_1$ | 0.8617 pu (0 deg) | 0.6715 pu (0 deg) | 1.0475 pu (0 deg) |
| $v_2$ | 0.7978 pu (-2.6846 deg) | 0.6218 pu (-2.6733 deg) | 0.9698 pu (-2.6989 deg) |
| $v_3$ | 1.6601 pu (-0.5102 deg) | 2.1731 pu (-0.5050 deg) | 1.0399 pu (-0.5168 deg) |
| M | N/A | N/A | 4.1228 ($\approx$N+1) |
| J | 4023 | 16440 | 0.0201 |
| eig(V) | $3.010 \times 10^{-4}$, 0.990, 4.135 | $3.014 \times 10^{-4}$, 1.414, 5.559 | $1.037 \times 10^{-9}$, $3.836 \times 10^{-3}$, 3.119 |
| Exec. Time (s) | 1.7 | 1.6 | 2 |

The convex relaxation approach for power system state estimation (PSSE) described herein has various advantages compared to other existing PSSE techniques. First, the proposed relaxation problem is convex, making it efficiently solvable and ensuring a near-optimal solution without the risk of getting stuck in local optima or facing convergence issues. Second, the new relaxation approach to rank constraints allows for the handling of constraints that are linearly related to voltages. These constraints are typically in the form of equality constraints. Third, the proposed rank relaxation method is more accurate (in terms of approximating the rank constraint, which results in an estimated state matrix that is closer to a rank-1 matrix compared to other existing techniques. The approximation of the rank function is based on the tightest mathematical bound defined in terms of nuclear norm on the convex envelope of the rank function. Finally, the semidefinite relaxation method proposed herein allows for handling constraints more easily compared to weighted least squares techniques.

The various aspects illustrated by logical blocks, modules, circuits, processes, algorithms, and algorithm steps described above may be implemented as electronic hardware, software, or combinations of both. Certain disclosed components, blocks, modules, circuits, and steps are described in terms of their functionality, illustrating the interchangeability of their implementation in electronic hardware or software. The implementation of such functionality varies among different applications given varying system architectures and design constraints. Although such implementations may vary from application to application, they do not constitute a departure from the scope of this disclosure.

Aspects of embodiments implemented in software may be implemented in program code, application software, application programming interfaces (APIs), firmware, middleware, microcode, hardware description languages (HDLs), or any combination thereof. A code segment or machine-executable instruction may represent a procedure, a function, a subprogram, a routine, a subroutine, a module, a software package, a class, or any combination of instructions, data structures, or program statements. A code segment may be coupled to, or integrated with, another code segment or an electronic hardware by passing or receiving information, data, arguments, parameters, memory contents, or memory locations. Information, arguments, parameters, data, etc. may be passed, forwarded, or transmitted via any suitable means including memory sharing, message passing, token passing, network transmission, etc.

The actual software code or specialized control hardware used to implement these systems and methods is not limiting of the claimed features or this disclosure. Thus, the operation and behavior of the systems and methods were described without reference to the specific software code being understood that software and control hardware can be designed to implement the systems and methods based on the description herein.

When implemented in software, the disclosed functions may be embodied, or stored, as one or more instructions or code on or in memory. In the embodiments described herein, memory includes non-transitory computer-readable media, which may include, but is not limited to, media such as flash memory, a random access memory (RAM), read-only memory (ROM), erasable programmable read-only memory (EPROM), electrically erasable programmable read-only memory (EEPROM), and non-volatile RAM (NVRAM). As used herein, the term "non-transitory computer-readable media" is intended to be representative of any tangible, computer-readable media, including, without limitation, non-transitory computer storage devices, including, without limitation, volatile and non-volatile media, and removable and non-removable media such as a firmware, physical and virtual storage, CD-ROM, DVD, and any other digital source such as a network, a server, cloud system, or the Internet, as well as yet to be developed digital means, with the sole exception being a transitory propagating signal. The methods described herein may be embodied as executable instructions, e.g., "software" and "firmware," in a non-transitory computer-readable medium. As used herein, the terms "software" and "firmware" are interchangeable and include any computer program stored in memory for execution by personal computers, workstations, clients, and servers. Such instructions, when executed by a processor, configure the processor to perform at least a portion of the disclosed methods.

As used herein, an element or step recited in the singular and proceeded with the word "a" or "an" should be understood as not excluding plural elements or steps unless such exclusion is explicitly recited. Furthermore, references to "one embodiment" of the disclosure or an "exemplary" or "example" embodiment are not intended to be interpreted as excluding the existence of additional embodiments that also incorporate the recited features. Likewise, limitations associated with "one embodiment" or "an embodiment" should not be interpreted as limiting to all embodiments unless explicitly recited.

Disjunctive language such as the phrase "at least one of X, Y, or Z," unless specifically stated otherwise, is generally intended, within the context presented, to disclose that an item, term, etc. may be either X, Y, or Z, or any combination thereof (e.g., X, Y, and/or Z). Likewise, conjunctive language such as the phrase "at least one of X, Y, and Z," unless specifically stated otherwise, is generally intended, within the context presented, to disclose at least one of X, at least one of Y, and at least one of Z.

The disclosed systems and methods are not limited to the specific embodiments described herein. Rather, components of the systems or steps of the methods may be utilized independently and separately from other described components or steps.

This written description uses examples to disclose various embodiments, which include the best mode, to enable any person skilled in the art to practice those embodiments, including making and using any devices or systems and performing any incorporated methods. The patentable scope is defined by the claims and may include other examples that occur to those skilled in the art. Such other examples are intended to be within the scope of the claims if they have structural elements that do not differ from the literal language of the claims, or if they include equivalent structural elements with insubstantial differences form the literal language of the claims.

**Claims**

1. A method (400) for power system state estimation, the method comprising:

   acquiring (402), by a computer system (300), from remote terminal units, measurement data of a plurality of parameters of a power system;
   acquiring (404), by the computer system, network topology data of the power system; and
   determining (406), by the computer system, estimates of a plurality of states of the power system using the measurement data, the network topology data and a semidefinite relaxation formulation, the semidefinite relaxation formulation including a convex lower bound approximation of a rank function of an augmented state matrix.

2. The method of claim 1, wherein the one or more processors are configured to acquire the measurement data in real time or near real time.

3. The method of claim 1 or 2, wherein the plurality of parameters of the power system include at least one of:

   one or more active power flow parameters;
   one or more reactive power flow parameters;
   one or more power injection parameters;
   one or more voltage magnitude parameters;
   one or more voltage phase parameters;
   one or more current magnitude parameters; or
   one or more current phase parameters.

4. The method of any of claims 1-3, wherein the plurality of states of the power system include voltage magnitudes and voltages phases of a plurality of buses of the power system.

5. The method of any of claims 1-4, wherein the convex lower bound approximation is based on a convex envelope of the rank function of the augmented state matrix, the convex envelope defined in terms of a nuclear norm and 2-norm of the augmented state matrix.

6. The method of claim 5, wherein the semidefinite relaxation formulation is convex.

7. The method of any of claims 1-6, wherein the semidefinite relaxation formulation includes one or more constraints that are linearly related to the plurality of states of the power system, the one or more constraints including at least one of:

an equality constraint related to voltage parameters of the power system;
an equality constraint related to current parameters of the power system;
an equality constraint related phase parameters of the power system; or
an equality constraint related to line admittance parameters of the power system.

8. The method of any of claims 1-7, wherein the network topology data includes one or more states of one or more circuit breakers or circuit switches .

9. The method of any of claims 1-8, comprising:
determining, by the computer system, based on the estimates of the plurality of states of the power system, whether the power system is operating normal operation conditions.

10. The method of claim 9, comprising, upon determining that the power system is not operating in normal operation conditions, performing at least one of:

generating one or more alert signal indicative of one or more abnormal operation conditions;
adjusting one or more parameters of the power system; or
modifying a network topology of the power system.

11. A system for power system state estimation, the system comprising:

one or more processors (302); and
a memory (304, 306) storing computer instructions (316), the computer instructions when executed by the one or more processors cause the one or more processors to perform a method according to any of claims 1-10.

FIG. 1

**FIG. 2**

FIG. 3

400

| Acquire measurement data of a plurality of parameters of a power system 402 |

↓

| Acquire network topology data of the power system 404 |

↓

| Determine estimates of a plurality of states of the power system using the measurement data, the network topology data and a semidefinite relaxation formulation including a convex lower-bound approximation of a rank function of an augmented state matrix 406 |

# FIG. 4

FIG. 5A

FIG. 5B

FIG. 6A

FIG. 6B

## EUROPEAN SEARCH REPORT

Europäisches
Patentamt
European
Patent Office
Office européen
des brevets

**Application Number**

EP 26 15 6027

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KLAUBER CECILIA ET AL: "Distribution system state estimation using semidefinite programming", 2015 NORTH AMERICAN POWER SYMPOSIUM (NAPS) IEEE, 4 October 2015 (2015-10-04), pages 1-6, XP032816331, DOI: 10.1109/NAPS.2015.7335195 [retrieved on 2015-11-20] * the whole document * | 1-11 | INV. H02J3/06 H02J13/12 ADD. H02J13/10 |
| X | VASSILIS KEKATOS ET AL: "PSSE Redux: Convex Relaxation, Decentralized, Robust, and Dynamic Approaches", ARXIV.ORG CORNELL UNIVERSITY LIBRARY, 201 OLIN LIBRARY CORNELL UNIVERSITY ITHACA, NY 14853, 14 August 2017 (2017-08-14), XP080952707, * the whole document * | 1-11 | |
| X | ZHU HAO ET AL: "Power System Nonlinear State Estimation Using Distributed Semidefinite Programming", ARXIV CORNELL UNIVERSITY, vol. 8, no. 6, 1 December 2014 (2014-12-01), pages 1039-1050, XP011564643, ISSN: 1932-4553, DOI: 10.1109/JSTSP.2014.2331033 [retrieved on 2014-11-18] * the whole document * | 1-11 | **TECHNICAL FIELDS SEARCHED (IPC)** H02J |

The present search report has been drawn up for all claims

| Place of search | Date of completion of the search | Examiner |
|---|---|---|
| Munich | 20 May 2026 | Hartmann, Martin |

EPO FORM 1503 03.82 (P04C01)